# EUROPEAN PATENT SPECIFICATION

(11) **EP 2 945 194 B1**
(45) Date of publication and mention of the grant of the patent: **30.11.2016**
(21) Application number: 14707428.0
(22) Date of filing: 09.01.2014
(51) Int. Cl.: H01L 31/052

(54) **COOLING SYSTEM AND METHOD FOR PHOTOVOLTAIC SOLAR PANELS**
KÜHLORRICHTUNG UND KÜHLVERFAHREN FÜR PHOTOVOLTAISCHE MODULEN
SYSTÈME ET PROCÉDÉ DE RÉFRIGÉRATION POUR PANNEAUX SOLAIRES PHOTOVOLTAÏQUES

(30) Priority: 11.01.2013 ES 201330023
(43) Date of publication of application: 18.11.2015
(73) Proprietor: Fernandez de Córdoba Sanz, Fernando, 28109 Alcobendas (Madrid) (ES)
(72) Inventor: Fernandez de Córdoba Sanz, Fernando, 28109 Alcobendas (Madrid) (ES)
(74) Representative: Carpintero Lopez, Francisco
(86) International application number: PCT/ES2014/070010
(87) International publication number: WO 2014/108592

(56) References cited:
- US-A- 2 093 808
- US-A1- 2012 152 318
- David's Tlug info: "Water cooling of photovoltaic panels", internet , 1 March 2012 (2012-03-01), XP002724429, Retrieved from the Internet: URL:http://tlug.webs.bailey.homelinux.net/ solar/ [retrieved on 2012-03-01]

## Description

### Object of the Invention

The present invention belongs to the field of renewable energies, and more specifically to cooling apparatuses or means for photovoltaic solar panels.

The main object of the present invention is a cooling system and a cooling method for photovoltaic solar panels that allow increasing their performance by keeping their surface at optimal temperature values, while at the same time it allows cleaning dust or fouling residues off of said surface, even further optimizing, if possible, the final work and performance of said panels.

### Background of the Invention

Installations consisting of photovoltaic solar panels, hereinafter PV panels, for obtaining electricity directly from solar radiation, through a plurality of semiconductor devices (photovoltaic cells) installed in said PV panels, are well-known today. More particularly, there are basically three types of installations for producing electric power based on the photovoltaic effect: solar installation with a fixed plate; installation with single-axis solar tracking; installation with dual-axis solar tracking.

In all of them, the system for generating electric power is the same, i.e., a material manufactured for that purpose (mono- or polycrystalline photoelectric silicon cell, or thin film silicon amorphous), it absorbs the luminous photons coming from solar radiation, and as they enter an excitation state, said photoelectric cells release energy by emitting free electrons (electricity). This is known as the photovoltaic effect.

The document by David TLUG available on the internet site http://tlug.webs.bailey.homelinux.net/solar is a closesly related prior art.

There are currently several countries which have passed suitable laws and regulations for encouraging the establishment of solar installations and thus having a non-depletable, clean and renewable energy source. Virtually from the onset of solar technology, the tests conducted in various laboratories have determined that the optimal operating temperature of the PV panels is in the range comprised between 20 and 30°C, assuming that there will always be a series of losses generated as a result of the photovoltaic cells working at temperatures exceeding the optimal temperature, generally between 40-60°C and even higher, due to the heating of the cells by the action of solar radiation. This causes the PV panels to frequently work below their ideal performance of 100%. Furthermore, another detrimental side effect of said overheating is the early deterioration of the PV panels, their service life being shortened and having a much lower performance after a few years of operation.

Therefore, current attempts to avoid said temperature increase in solar panels have been unsuccessful primarily due to the fact that even though there are cooling systems capable of controlling the panel heating effect, the economic and energy cost thereof is generally very high and is not worth it for investing companies because the vast majority of them use electricity to run additional cooling machines. Furthermore, they are also unable to remove the dust covering the surface, likewise affecting theirperformance. Therefore, most solar installations today are exposed to the elements, without any thermal protection of any type.

In summary, the drawbacks of current photovoltaic solar panels are mainly:
- They work at a temperature above their optimal operating value, which causes a substantial loss in their performance.
- They accumulate a layer of dust, particles and fouling that are deposited on their surface, negatively affecting their performance.
- The preceding points cause early deterioration of the internal components of said PV panels, hence affecting their normal operation.
- Furthermore, the preceding point causes the associated repair, replacement and maintenance costs for parts to rise considerably, thereby increasing the cost of the installation.

### Description of the Invention

The present invention solves the aforementioned drawbacks by providing a cooling system as recited in claim 1 and method as recited in claim 8 for photovoltaic solar panels, hereinafter PV panels, which allow increasing the performance of solar panels by keeping their surface at optimal operating temperature values, while at the same time it allows cleaning and removing dust and/or fouling residue existing on said surface, even further optimizing, if possible, their final performance.

More particularly, the cooling system object of invention is particularly applicable to PV panels of the type that are installed in an inclined position with respect to the horizontal plane for optimal solar radiation capture, said cooling system comprising fluid sprayers arranged on the upper edge of the PV panels for supplying a continuous or discontinuous sheet of fluid over the outer surface of the PV panels; a collection tray fixed to the lower edge of the PV panels to collect and channel the excess fluid coming from said outer surface of the PV panels; a drain hose linked at one of its ends to the collection tray to extract the fluid housed in the collection tray.

Furthermore, the cooling system of the present invention comprises a first tank arranged outdoors for storing and cooling the fluid extracted through the drain hose, and a second thermally insulated tank suitable for receiving the low-temperature fluid coming from the first tank by means of an electric pump, said second tank having an outlet duct for recirculating the fluid back towards the fluid sprayers of the PV panels.

It should be indicated that with said second thermally insulated tank that is insulated by means of polyurethane foam, for example, the fluid does not experience significant temperature variations for the longest possible time in order to be recirculated back to the fluid sprayers.

In turn, although the electric pump is preferably connected to the power grid, it has been envisaged that the cooling system herein described may comprise a standalone solar panel equipment for the additional power supply of said electric pump.

On the other hand, the fluid sprayers discussed above are preferably located on an elongated common rod installed along the upper edge of the PV panels, said fluid sprayers being able to be sprinklers, micro sprinklers, drip sprayers, sheet sprayers or the like. In turn, the electric pump is preferably a combined, lift-force pump, and it is associated with a control unit managing the power supply to be provided to the pump.

It has also been envisaged that the fluid sprayers additionally comprise flow rate regulating means that allow the outflow of a larger or smaller amount of fluid according to the cooling needs of the PV panels, i.e., by balancing out the excessive heat that the PV panels may have during the day so that their performance is always close to 100%.

According to another object of the invention, a cooling method for PV panels is described below, said method comprising the following steps:
- outflow of fluid over the outer surface of the PV panels from fluid sprayers located on the upper edge thereof,
- collecting and channeling the excess fluid in a collection tray,
- extracting the fluid housed in the collection tray by means of a drain hose,
- storing and cooling the extracted fluid in a first tank located outdoors until said fluid reaches a minimum temperature,
- pumping the fluid once it is cooled to a second thermally insulated tank, and
- recirculating the fluid from the second tank towards the fluid sprayers of the PV panels.

The step of storing and cooling the fluid in the first tank is preferably performed until the time of day with the lowest outdoor temperature (which will generally be in the early morning hours every day).

Likewise, the step of recirculating fluid back towards the fluid sprayers of the PV panels is preferably performed by means of draining by gravity through the outlet duct of the aforementioned second tank, thereby providing simplicity, speed and a low economic cost of the installation.

### Description of the Drawings

To complement the description that is being made and for the purpose of aiding to better understand the features of the invention according to a preferred practical embodiment thereof, a set of drawings is attached as an integral part of said description in which the following has been depicted with an illustrative and nonlimiting character:
Figure 1 shows a schematic view of the different elements involved in the cooling system for photovoltaic solar panels object of invention.
Figure 2 shows a perspective view of a photovoltaic solar panel incorporating the cooling system of the present invention.

### Preferred Embodiment of the Invention

A preferred embodiment is described below making reference to the aforementioned drawings, without this limiting or reducing the scope of protection of the present invention.

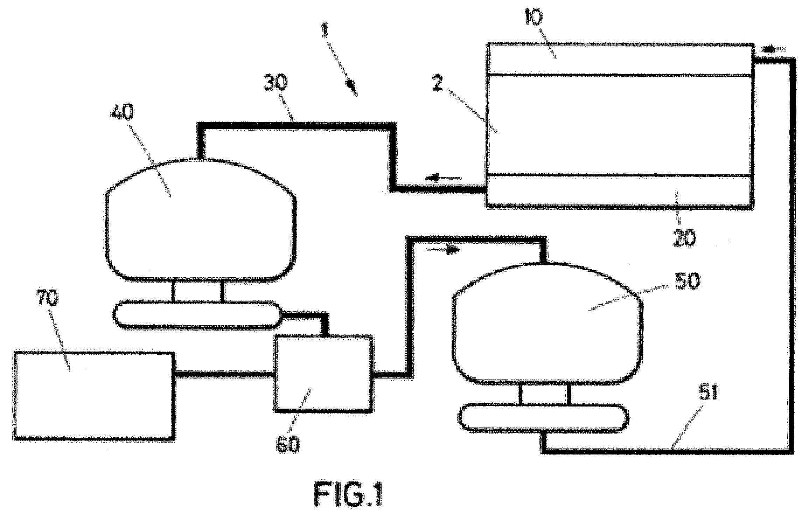

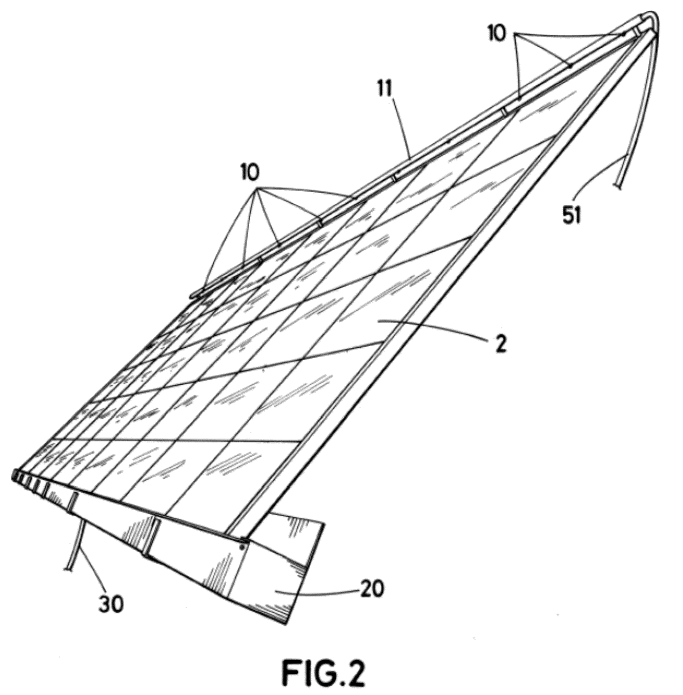

Figure 1 schematically shows the different component elements of the cooling system of the invention, which comprises:
- fluid sprayers (10), shown more clearly in Figure 2, located on an elongated common rod (11) installed along the upper edge of the PV panels (2), which allow supplying a sheet of fluid over the outer surface of said PV panels (2),
- a collection tray (20) fixed to the lower edge of the PV panels (2) to collect and channel the excess fluid coming from said outer surface of the PV panels (2),
- a drain hose (30) linked at one of its ends to the collection tray (20) to extract the fluid housed in the collection tray (20),
- a first tank (40) arranged outdoors for storing and cooling the fluid extracted through the drain hose (30), and
- a second thermally insulated tank (50) that is suitable for receiving the low-temperature fluid coming from the first tank (40) by means of an combined electric pump (60), said second tank (50) having an outlet duct (51) for recirculating the fluid towards the fluid sprayers (10) of the PV panels (2), and
- a standalone solar panel equipment (70) for the additional power supply of the electric pump (60).

Therefore, the present invention provides a closed cooling circuit for PV panels (2) which allows reducing the temperature of their outer surface to an optimal operating value (about 25°C), said panels (2) being cooled based on the outside temperature at the most favorable time of day, i.e., when the outside temperature is the minimum temperature, and also removing fouling and dust residues that may be covering the outer surface of said PV panels (2).

## Claims

1. Cooling system (1) for photovoltaic solar panels (2), of the type that are installed in an inclined position with respect to the horizontal plane for optimal solar radiation capture, said cooling system (1) comprising:
- fluid sprayers (10) arranged on the upper edge of the PV panels (2) for supplying a sheet of fluid over their outer surface,
- a collection tray (20) fixed to the lower edge of the PV panels (2) to collect and channel the excess fluid coming from said outer surface of the PV panels (2),
- a drain hose (30) linked at one of its ends to the collection tray (20) to extract the fluid housed therein,
**characterized in that** the cooling system (1) further comprises:
- a first tank (40) arranged outdoors for storing and cooling the fluid extracted through the drain hose (30), and
- a second tank (50) for receiving the low-temperature fluid coming from the first tank (40) by means of an electric pump (60), wherein said second tank (50) is thermally insulated so that the fluid does not experience significant temperature variations for the longest possible time in order to be recirculated back to the fluid sprayers (10), said second tank (50) having an outlet duct (51) for recirculating the fluid towards the fluid sprayers (10) of the PV panels (2).

2. Cooling system (1) for photovoltaic solar panels (2) according to claim 1, **characterized in that** it additionally comprises a standalone solar panel equipment (70) for the additional power supply of the electric pump (60).

3. Cooling system (1) for photovoltaic solar panels (2) according to claim 1, **characterized in that** the fluid sprayers (10) are located on an elongated common rod (11) installed along the upper edge of the PV panels (2).

4. Cooling system (1) for photovoltaic solar panels (2) according to any one of claims 1 or 3, **characterized in that** the fluid sprayers (10) are sprinklers, micro sprinklers, drip sprayers, sheet sprayers or the like.

5. Cooling system (1) for photovoltaic solar panels (2) according to any one of claims 1, 3 or 4, **characterized in that** the fluid sprayers (10) additionally comprise flow rate regulating means.

6. Cooling system (1) for photovoltaic solar panels (2) according to claim 1, **characterized in that** the electric pump (60) is a combined, lift-force pump.

7. Cooling system (1) for photovoltaic solar panels (2) according to any one of claims 1 or 6, **characterized in that** the electric pump (60) is associated with a control unit managing the power supply to be provided to the pump (60).

8. Cooling method for photovoltaic solar panels, said cooling method comprises the following steps:
- outflow of fluid over the outer surface of the PV panels (2) from fluid sprayers (10) located on the upper edge thereof,
- collecting and channeling the excess fluid in a collection tray (20),
- extracting the fluid housed in the collection tray (20) by means of a drain hose (30),
**characterized in that** the cooling method further comprises:
- storing and cooling the extracted fluid in a first tank (40) located outdoors until said fluid reaches a minimum temperature,
- pumping the fluid once it is cooled to a second tank (50), said second tank (50) being thermally insulated so that the fluid does not experience significant temperature variations for the longest possible time, and
- recirculating the fluid from the second tank (50) towards the fluid sprayers (10) of the PV panels (2), said panels (2) being cooled based on the outside temperature at the most favorable time of day, in particular when the outside temperature is the minimum temperature.

9. Cooling method according to claim 8, **characterized in that** the step of storing and cooling the fluid in the first tank (40) is performed until the time of day with the lowest outdoor temperature.

10. Cooling method according to claim 8, **characterized in that** the step of recirculating fluid is performed by means of draining by gravity.

## Patentansprüche

1. - Kühlsystem (1) für photovoltaische Solarpanels (2) des Typs, der zum optimalen Einfangen von Sonnenstrahlung in einer geneigten Stellung bezüglich der horizontalen Ebene installiert ist, wobei das Kühlsystem (1) umfasst:
- Fluid-Sprüheinrichtungen (10), angeordnet an der Oberkante der Photovoltaikpanels (2) zum Zuführen einer Fläche von Fluid über ihrer Außenfläche,
- einen Sammeltrog (20), befestigt an der Unterkante der Photovoltaikpanels (2) zum Sammeln und Kanalisieren des überschüssigen Fluids, das von der Außenfläche der Photovoltaikpanels (2) kommt,
- einen Ablaufschlauch (30), verbunden an einem seiner Enden mit dem Sammeltrog (20), um das darin befindliche Fluid abzuziehen,
**dadurch gekennzeichnet, dass** das Kühlsystem (1) weiter umfasst:
- einen ersten Behälter (40), angeordnet im Freien zum Speichern und Kühlen des durch den Ablaufschlauch (30) abgezogenen Fluids, und
- einen zweiten Behälter (50) zum Empfangen des vom ersten Behälter (40) kommenden Fluids niedriger Temperatur mittels einer elektrischen Pumpe (60), wobei der zweite Behälter (50) wärmegedämmt ist, sodass das Fluid über die längstmögliche Zeit keine bedeutenden Temperaturänderungen erfährt, um zu den Fluid-Sprüheinrichtungen (10) zurückgeführt zu werden, wobei der zweite Behälter (50) eine Auslassleitung (51) zum Rückführen des Fluids zu den Fluid-Sprüheinrichtungen (10) der Photovoltaikpanels (2) aufweist.

2. - Kühlsystem (1) für photovoltaische Solarpanels (2) nach Anspruch 1, **dadurch gekennzeichnet, dass** es außerdem eine eigenständige Solarpaneleinrichtung (70) für die zusätzliche Stromversorgung der elektrischen Pumpe (60) umfasst.

3. - Kühlsystem (1) für photovoltaische Solarpanels (2) nach Anspruch 1, **dadurch gekennzeichnet, dass** sich die Fluid-Sprüheinrichtungen (10) auf einer länglichen gemeinsamen Stange (11) befinden, die entlang der Oberkante der Photovoltaikpanels (2) installiert ist.

4. - Kühlsystem (1) für photovoltaische Solarpanels (2) nach einem der Ansprüche 1 oder 3, **dadurch gekennzeichnet, dass** die Fluid-Sprüheinrichtungen (10) Sprinkler, Mikrosprinkler, Tröpfelsprüher, Flächensprüher oder dergleichen sind.

5. - Kühlsystem (1) für photovoltaische Solarpanels (2) nach einem der Ansprüche 1, 3 oder 4, **dadurch gekennzeichnet, dass** die Fluid-Sprüheinrichtungen (10) außerdem Durchflussregulierungseinrichtungen umfassen.

6. - Kühlsystem (1) für photovoltaische Solarpanels (2) nach Anspruch 1, **dadurch gekennzeichnet, dass** die elektrische Pumpe (60) eine kombinierte Auftriebspumpe ist.

7. - Kühlsystem (1) für photovoltaische Solarpanels (2) nach einem der Ansprüche 1 oder 6, **dadurch gekennzeichnet, dass** die elektrische Pumpe (60) mit einer Steuereinheit verbunden ist, die die für die Pumpe (60) vorzusehende Stromversorgung verwaltet.

8. - Kühlverfahren für photovoltaische Solarpanels, wobei das Kühlverfahren die folgenden Schritte umfasst:
- Ausströmen von Fluid über die Außenfläche der Photovoltaikpanels (2) aus an deren Oberkante befindlichen Fluid-Sprüheinrichtungen (10),
- Sammeln und Kanalisieren des überschüssigen Fluids in einem Sammeltrog (20),
- Abziehen des im Sammeltrog (20) befindlichen Fluids mittels eines Ablaufschlauchs (30),
**dadurch gekennzeichnet, dass** das Kühlverfahren weiter umfasst:
- Speichern und Kühlen des abgezogenen Fluids in einem im Freien angeordneten ersten Behälter (40), bis das Fluid eine Tiefsttemperatur erreicht,
- Pumpen des Fluids nach dem Abkühlen in einen zweiten Behälter (50), wobei der zweite Behälter (50) wärmegedämmt ist, sodass das Fluid über die längstmögliche Zeit keine bedeutenden Temperaturänderungen erfährt, und
- Rückführen des Fluids von dem zweiten Behälter (50) zu den Fluid-Sprüheinrichtungen (10) der Photovoltaikpanels (2), wobei die Panels (2) auf Grundlage der Außentemperatur zur günstigsten Tageszeit gekühlt werden, insbesondere wenn die Außentemperatur die Tiefsttemperatur ist.

9. - Kühlverfahren nach Anspruch 8, **dadurch gekennzeichnet, dass** der Schritt des Speicherns und Kühlens des Fluids in dem ersten Behälter (40) bis zu der Tageszeit mit der niedrigsten Außentemperatur durchgeführt wird.

10. - Kühlverfahren nach Anspruch 8, **dadurch gekennzeichnet, dass** der Schritt des Rückführens von Fluid mittels Ablaufens durch Schwerkraft durchgeführt wird.

## Revendications

1. Système de refroidissement (1) pour panneaux solaires photovoltaïques (2), du type qui sont installés dans une position inclinée par rapport au plan horizontal pour une capture optimale des rayonnements solaires, ledit système de refroidissement (1) comprenant :
- des pulvérisateurs de fluide (10) agencés sur le bord supérieur des panneaux PV (2) pour fournir un film de fluide sur leur surface externe,
- un plateau collecteur (20) fixé au bord inférieur des panneaux PV (2) pour collecter et canaliser l'excès de fluide provenant de ladite surface externe des panneaux PV (2),
- un tuyau souple d'évacuation (30) relié, à une de ses extrémités, au plateau collecteur (20) pour extraire le fluide logé dans celui-ci,
**caractérisé en ce que** le système de refroidissement (1) comprend en outre :
- un premier réservoir (140) agencé à l'extérieur pour stocker et refroidir le fluide extrait par le tuyau souple d'évacuation (30) et
- un second réservoir (50) pour recevoir le fluide à basse température provenant du premier réservoir (40) au moyen d'une pompe électrique (60), dans lequel ledit second réservoir (50) est isolé thermiquement de sorte que le fluide ne subisse pas de variations de température notables pendant la période de temps la plus longue possible afin d'être remis en circulation vers les pulvérisateurs de fluide (10), ledit second réservoir (50) ayant un conduit de sortie (51) pour remettre en circulation le fluide vers les pulvérisateurs de fluide (10) des panneaux PV (2).

2. Système de refroidissement (1) pour panneaux solaires photovoltaïques (2) selon la revendication 1, **caractérisé en ce qu'**il comprend de plus un équipement de panneau solaire autonome (70) pour l'alimentation électrique supplémentaire de la pompe électrique (60).

3. Système de refroidissement (1) pour panneaux solaires photovoltaïques (2) selon la revendication 1, **caractérisé en ce que** les pulvérisateurs de fluide sont situés sur une tige commune allongée (11) installée le long du bord supérieur des panneaux PV (2).

4. Système de refroidissement (1) pour panneaux solaires photovoltaïques (2) selon l'une quelconque des revendications 1 ou 3, **caractérisé en ce que** les pulvérisateurs de fluide (10) sont des têtes d'arrosage, des micro-têtes d'arrosage, des pulvérisateurs à jet d'eau, des pulvérisateurs en film ou analogue.

5. Système de refroidissement (1) pour panneaux solaires photovoltaïques (2) selon l'une quelconque des revendications 1, 3 ou 4, **caractérisé en ce que** les pulvérisateurs de fluide (10) comprennent de plus des moyens de régulation de débit.

6. Système de refroidissement (1) pour panneaux solaires photovoltaïques (2) selon la revendication 1, **caractérisé en ce que** la pompe électrique (60) est une pompe combinée à force de levage.

7. Système de refroidissement (1) pour panneaux solaires photovoltaïques (2) selon l'une quelconque des revendications 1 ou 6, **caractérisé en ce que** la pompe électrique (60) est associée à une unité de commande gérant l'alimentation électrique à fournir à la pompe (60).

8. Procédé de refroidissement pour panneaux solaires photovoltaïques, ledit procédé de refroidissement comprend les étapes suivantes :
- la décharge de fluide par-dessus la surface externe des panneaux PV (2) des pulvérisateurs de fluide (10) situés sur son bord supérieur,
- la collecte et la canalisation de l'excès de fluide dans un plateau collecteur (20),
- l'extraction du fluide logé dans le plateau collecteur (20) au moyen d'un tuyau souple d'évacuation (30),
**caractérisé en ce que** le procédé de refroidissement comprend en outre :
- le stockage et le refroidissement du fluide extrait dans un premier réservoir (40) situé à l'extérieur jusqu'à ce que ledit fluide atteigne une température minimale,
- le pompage du fluide une fois qu'il est refroidi vers un second réservoir (50), ledit second réservoir (50) étant thermiquement isolé de sorte que le fluide ne subisse pas de variations de température notables pendant la période de temps la plus longue possible, et
- la remise en circulation du fluide venant du second réservoir (50) vers les pulvérisateurs de fluide (10) des panneaux PV (2), lesdits panneaux (2) étant refroidis sur la base de la température externe au moment de la journée le plus favorable, en particulier lorsque la température externe est la température minimale.

9. Procédé de refroidissement selon la revendication 8, **caractérisé en ce que** l'étape de stockage et de refroidissement du fluide dans le premier réservoir (40) est effectuée jusqu'au moment de la journée ayant la température externe la plus basse.

10. Procédé de refroidissement selon la revendication 8, **caractérisé en ce que** l'étape de remise en circulation du fluide est effectuée au moyen d'une évacuation sous l'effet de la pesanteur.
